# EUROPÄISCHE PATENTANMELDUNG

(11) **EP 1 284 588 A2**
(43) Veröffentlichungstag der Anmeldung: **19.02.2003**
(21) Anmeldenummer: 02017830.7
(22) Anmeldetag: 08.08.2002
(51) Int. Cl.: H05H 1/30

(54) **Verfahren zur Überwachung von Plasma- oder Flammspritzverfahren**

(30) Priorität: 16.08.2001 DE 10140299
(71) Anmelder: MTU Aero Engines GmbH, 80995 München (DE); DaimlerChrysler AG, 70567 Stuttgart (DE)
(72) Erfinder: Bayer, Erwin, Dr., 85221 Dachau (DE); Höschele, Jörg, Dr., 88048 Friedrichshafen (DE); Schneiderbanger, Stefan, 85232 Lauterbach (DE); Steinwandel, Jürgen, Dr., 88690 Uhldingen-Mühlhofen (DE)
(74) Vertreter: Zacharias, Frank L.

(57) **Zusammenfassung**

Die Erfindung betrifft ein Verfahren zur Messung charakteristischer Eigenschaften eines Plasmastrahls in einem thermischen Spritzprozeß, wobei dem Plasma (1) Spritzmaterialien zugeführt werden und die vom Plasma (1) ausgesandte Lichtstrahlung auf Lichtleitfasern (2) abgebildet wird. Gemäß der Erfindung wird die Lichtstrahlung auf das eine Ende (2a) der in einem ein- oder zweidimensionalen Array (6) angeordneten Lichtleitfasern (2) abgebildet. Mittels eines am anderen Ende (2b) einer Lichtleitfaser (2) angeordneten Spektrometers (3) wird erfindungsgemäß eine Spektralzerlegung der in der Lichtleitfaser (2) geführten Lichtstrahlung durchgeführt. Außerdem werden die Frequenzspektren zur Ermittlung des momentanen Zustandes des Spritzprozesses in einem Prozessor (5) ausgewertet.

## Beschreibung

Die Erfindung betrifft ein Verfahren zur Überwachung von Plasma- oder Flammspritzverfahren gemäß dem Oberbegriff des Patentanspruchs 1.

Aus EP 0 542 542 B1 ist ein Verfahren zur zeitnahen (on-line) Erfassung von Pulverspritz-Partikeln in einem Plasmastrahl bekannt. Die von dem Plasmastrahl ausgesandte Lichtstrahlung wird auf ein Ende eines Lichtleiters fokussiert. An dem anderen Ende des Lichtleiters wird die Lichtstrahlung mittels einer dichroitischen Linse in zwei Lichtstrahlen aufgeteilt, welche jeweils einem Photodetektor zugeführt werden. In den Photodetektoren wird für jeden Lichtstrahl die zeitliche Intensitätsverteilung bestimmt. Mittels eines Filters das den Photodetektoren vorgeschaltet ist, können geeignete Wellenlängenbereiche aus der Lichtstrahlung gefiltert und deren zeitlicher Intensitätsverlauf bestimmt werden.

In EP 0 542 542 B1 wird auch die Möglichkeit beschrieben, ein Lichtleiterbündel zu verwenden und die empfangene Strahlung einer CCD-Kamera zuzuführen.

Ein weiteres Verfahren bei dem mittels Photodetektoren die zeitliche Intensitätsverteilung der von einem Plasma ausgesandten Lichtstrahlung bestimmt wird, ist aus US 5,986,277 bekannt.

Der Nachteil der bekannten Verfahren ist, dass ausschließlich die Bestimmung der Intensitätsverteilung der Lichtstrahlung des Plasmas möglich ist. Außerdem können mit den bekannten Verfahren nur die Geschwindigkeit und die Temperatur der Partikel bestimmt werden. So ist mit den bekannten Verfahren nur eine eingeschränkte Überwachung und Diagnose des momentanen Plasmazustandes möglich. Eine Überwachung der übrigen für den Spritzprozeß relevanten Prozeßgrößen ist nicht möglich. Zu dem, durch die Prozeßgrößen definierten Plasmazustand zählen dabei neben den oben beschriebenen Prozeßgrößen (Geschwindigkeit und Temperatur der Partikel) auch die Plasmazusammensetzung, die Zusammensetzung der Spritzmaterialien sowie der Gas- und Materialfluß.

Aufgabe der Erfindung ist es, ein Verfahren anzugeben, mit dem es möglich ist, neben der Geschwindigkeit und Temperatur der Partikel weitere Prozeßgrößen zeitnah zu ermitteln.

Diese Aufgabe wird mit dem Verfahren gemäß Patentanspruch 1 gelöst. Vorteilhafte Ausführungen der Erfindung sind Gegenstand von Unteransprüchen.

Erfindungsgemäß wird die Lichtstrahlung auf das eine Ende der in einem ein- oder zweidimensionalen Array angeordneten Lichtleitfasern abgebildet. Außerdem erfolgt erfindungsgemäß mittels eines am anderen Ende einer Lichtleitfaser angeordneten Spektrometers eine Spektralzerlegung der in der Lichtleitfaser geführten Lichtstrahlung. In einem Prozessor, z.B. in einer Datenverarbeitungsanlage, werden erfindungsgemäß die Spektren zur Ermittlung Prozeßgrößen des Spritzprozesses ausgewertet. Die Auswertung der Spektren erfolgt hierbei nach den einem Fachmann bekannten Verfahren.

Im Gegensatz zum Stand der Technik kann mit dem erfindungsgemäßen Verfahren für jede Lichtleitfaser der zeitliche Verlauf eines gesamten Spektrums bestimmt werden. Mittels des Spektrometers wird eine spektrale Auflösung von individuellen Bildpunkten (gebildet durch die einzelnen Lichtleitfasern) entlang des Plasmastrahls erreicht. Als Spektrometer kann vorteilhaft, aufgrund seiner geringen Größe ein Spektrometer, welches sich auf einer Einschubkarte für eine Datenverarbeitungsanlage (PC) befindet, verwendet werden.

Außerdem ist es möglich, aus den gemessenen Spektren anhand charakteristischer Spektrallinien Pulverspritzmaterialien sowie Gas- und Flüssigprecursoren zu identifizieren und deren zeitlichen Verlauf zu bestimmen. Eine Identifizierung der entsprechenden Spektrallinien ist für jede Lichtleitfaser unabhängig möglich. Es ist also insbesondere möglich, mittels des erfindungsgemäßen Verfahrens den Plasmastrahl räumlich und zeitlich hinsichtlich seines momentanen Prozeßzustands zu untersuchen.

Ein weiterer Vorteil ist, dass es z.B. möglich ist, gleichzeitig die Geschwindigkeiten mehrerer verschiedener im Plasmastrahl enthaltener Partikel zu bestimmen. Außerdem können gleichzeitig mehrere verschiedene Gas- und Materialflüsse im Plasmastrahl bestimmt werden. Dies ist besonders dann von großem Vorteil, wenn als Spritzmaterial nicht nur ein Pulvermaterial, sondern z.B. eine Pulvermischung verwendet wird.

Außerdem kann mit dem erfindungsgemäßen Verfahren die Stabilität des Plasmastrahls bestimmt werden, was einen entscheidenden Einfluß auf die Qualität des Spritzprozesses hat.

In einer vorteilhaften Ausführung der Erfindung ist es möglich, die Lichtstrahlung der einzelnen Lichtleitfasern des erfindungsgemäßen Arrays sequentiell einem einzigen Spektrometer zuzuführen. Das Array kann hierbei insbesondere ein Linienarray oder ein quadratisches oder rechteckiges Array, z.B. mit einer 4x4- oder 5x5- Matrix sein.

Hierbei wird jede Lichtleitfaser im Array sequentiell abgefragt und somit die Lichtstrahlung sequentiell dem Spektrometer durchgeführt. Der Vorteil hierbei ist eine erhebliche Raum- und Kosteneinsparung der für das Verfahren benötigten Komponenten. Mittels den einem Fachmann bekannten Schaltungen ist ein Umschalten der einzelnen Lichtleitfasern auf das Spektrometer ohne großen Zeitverlust möglich.

Mit dem erfindungsgemäßen Verfahren ist somit eine umfassende Überwachung und on-line Diagnose eines thermischen Spritzprozesses möglich.

In einer weiteren vorteilhaften Ausführung der Erfindung ist es möglich, mittels dem aus den Spektren ermittelten Prozeßzustand die Prozeßparameter des Spritzprozesses zu regeln. Dabei ist es z.B. möglich die Gas- und Materialflüsse des Plasmastrahls und des in das Plasma eingespeisten Spritzmaterials zu regeln.

Die Erfindung wird im folgenden beispielhaft anhand von Zeichnungen näher erläutert. Es zeigen:
Fig. 1 : eine erste Ausführungsform zur Durchführung des erfindungsgemäßen Verfahrens,
Fig. 2 : eine zweite Ausführungsform zur Durchführung des erfindungsgemäßen Verfahrens.

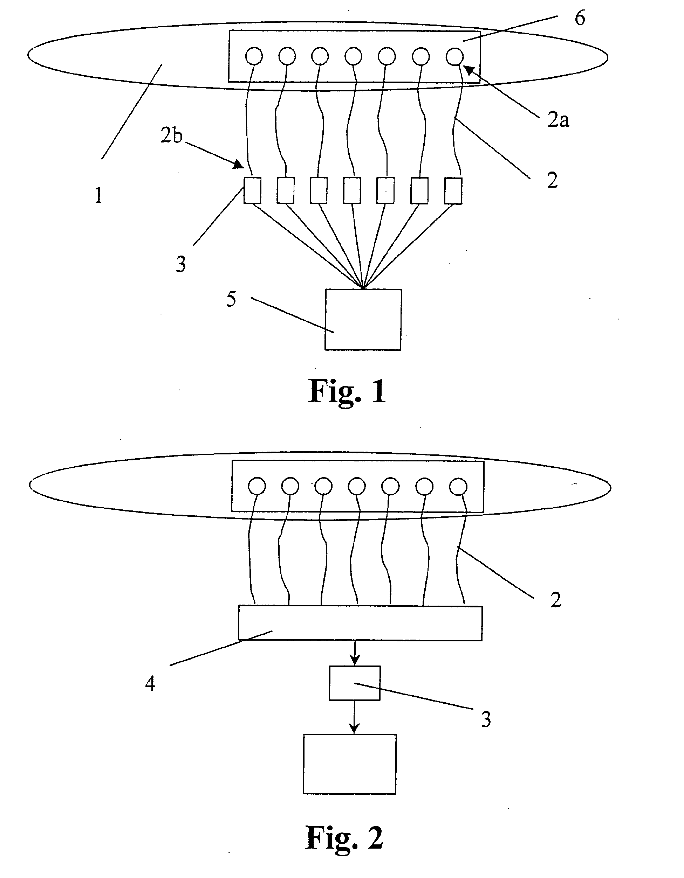

Fig. 1 zeigt eine erste Ausführungsform zur Durchführung des erfindungsgemäßen Verfahrens. Hierbei sind die Lichtleitfasern 2 in einem beispielhaften eindimensionalen Array 6 angeordnet. Selbstverständlich ist auch ein zweidimensionales Array möglich. Das von dem Plasma 1 abgestrahlte Licht wird auf das eine Ende 2a der Lichtleitfasern 2 abgebildet. Am anderen Ende 2b jeder Lichtleitfaser 2 wird das in der Lichtleitfaser 2 transportierte Licht des Plasmas 1 in jeweils einem Spektrometer 3 in seine Spektralanteile zerlegt. Die in den einzelnen Spektrometern 3 erzeugten Frequenzspektren werden in einem Prozessor 5, z.B. einem Computer weiterverarbeitet.

In Fig. 2 ist eine zweite Ausführungsform zur Durchführung des erfindungsgemäßen Verfahrens dargestellt. Dabei entspricht der Aufbau in Fig. 2 im wesentlichen dem in Fig. 1 beschrieben Aufbau. Allerdings werden in der in Fig. 2 dargestellten Ausführungsform die einzelnen Lichtleitfasern 2 einer Verteilerschaltung 4 zugeführt. Diese Verteilerschaltung 4 leitet nun die Informationen der einzelnen Lichtleitfasern 2 sequentiell zu dem Spektrometer 3. Die Verteilerschaltung 4 kann dabei selbstverständlich von einer nicht dargestellten Steuerschaltung gesteuert werden.

## Patentansprüche

1. Verfahren zur Messung charakteristischer Eigenschaften eines Plasmastrahls in einem thermischen Spritzprozeß, wobei dem Plasma Spritzmaterialien zugeführt werden und die vom Plasma (1) ausgesandte Lichtstrahlung auf Lichtleitfasern (2) abgebildet wird, **dadurch gekennzeichnet, dass**
- die Lichtstrahlung auf das eine Ende (2a) der in einem ein- oder zweidimensionalen Array (6) angeordneten Lichtleitfasern (2) abgebildet wird,
- mittels eines am anderen Ende (2b) einer Lichtleitfaser angeordneten Spektrometers (3) eine Spektralzerlegung der in der Lichtleitfaser (2) geführten Lichtstrahlung erfolgt,
- die Frequenzspektren in einem Prozessor (5) zur Ermittlung des momentanen Zustandes des Spritzprozesses ausgewertet werden.

2. Verfahren nach Anspruch 1, **dadurch gekennzeichnet, dass** die Lichtstrahlung der einzelnen Lichtleitfasern (2) des Arrays (6) sequentiell einem Spektrometer (3) zugeführt wird.

3. Verfahren nach einem der vorangehenden Ansprüche, **dadurch gekennzeichnet, dass** mittels dem aus den Spektren ermittelten Prozeßzustand die Prozeßparameter des Spritzprozesses, insbesondere die Gas- und/oder Materialflüsse geregelt werden.

4. Verfahren nach einem der vorangehenden Ansprüche, **dadurch gekennzeichnet, dass** als Spektrometer (3) ein auf einer Einschubkarte für eine Datenverarbeitungsanlage befindliches Spektrometer verwendet wird.
